# EUROPEAN PATENT APPLICATION

(11) **EP 4 672 611 A2**
(43) Date of publication of application: **31.12.2025**
(21) Application number: 24792871.6
(22) Date of filing: 25.03.2024
(51) Int. Cl.: H03K 19/177, G04F 10/00

(54) **TDC INCLUDING MULTIPLEXER RECONFIGURING INPUT SIGNAL, AND FPGA INCLUDING SAME**

(30) Priority: 21.04.2023 KR 20230052774
(71) Applicant: SDT Inc., Seoul 06211 (KR)
(72) Inventor: PARK, Byung Kwon, Suwon-si Gyeonggi-do 16238 (KR); YUNE, Jiwon, Gwacheon-si Gyeonggi-do 13839 (KR)
(74) Representative: Manasse, Uwe
(86) International application number: PCT/KR2024/003681
(87) International publication number: WO 2024/219684

(57) **Abstract**

Disclosed is an FPGA programmed to include a plurality of TDCs, wherein each said TDC is configured to determine a time difference between the occurrences of two signals and has an input node pair for receiving said two signals, and a multiplexer configured to selectively connect a plurality of input signals to the input node pair of each of said TDCs.

## Description

### Detailed Description of the Invention

The present invention relates to a technology for FPGAs, and more particularly, to a technology for an FPGA that includes a TDC (Time-to-Digital Converter) which includes a multiplexer for reconfiguring input signals.

A TDC (Time-to-Digital Converter) is a device or circuit that converts the time interval between two events into a digital output. TDCs play a crucial role in many scientific and industrial applications that require precise timing measurements. They are widely used in applications requiring high-precision timing measurements, such as time-of-flight (TOF) measurements in particle physics, medical imaging, radar systems, and laser range finding. A TDC operates by measuring the time difference between two events, for example, the arrival or dispatch and reflection of a signal at two points in a circuit. Generally, a counter is used to count the number of clock periods between two events. Then, the count is converted into a digital output representing the time interval. There are various types of TDCs, such as leading-edge TDCs, trailing-edge TDCs, and interpolation TDCs. A leading-edge TDC measures the time between the leading edge of a start signal and the leading edge of a stop signal, while a trailing-edge TDC measures the time between the trailing edge of a start signal and the trailing edge of a stop signal. An interpolation TDC increases the resolution of the TDC by using interpolation techniques to estimate the time interval between two clock periods.

TDCs can be implemented using ASICs (Application-Specific Integrated Circuits), MCUs (Microcontrollers), PSoCs (Programmable System-on-Chip), DSPs (Digital Signal Processors), FPAAs (Field Programmable Analog Arrays), TACs (Time-to-Amplitude Converters), TFCs (Time-to-Frequency Converters), and FPGAs (Field Programmable Gate Arrays).

When implementing a TDC using an FPGA, the following problems may arise. First, the resources provided in an FPGA, including logic cells, look-up tables (LUTs), and routing channels, are limited, which can limit the resolution and accuracy of the TDC implemented in the FPGA. Second, at high clock frequencies, jitter can introduce errors into the TDC measurement. Here, jitter refers to variations in the timing of a clock signal due to factors such as noise and temperature. Third, due to factors such as voltage drops, temperature changes, and manufacturing process variations, the TDC may exhibit non-linear behavior, which can cause errors in high-resolution TDC measurements. Fourth, FPGAs introduce delays through signal processing and routing, and these delays can introduce errors into TDC measurements for small time intervals.

Routing in an FPGA refers to the process of connecting programmable logic elements (e.g., look-up tables, flip-flops, and multiplexers) on the chip to form a desired logic circuit. Routing determines how signals propagate through the chip and has a significant impact on the overall performance of the design. One of the main factors that can cause delays in FPGA routing is the capacitance of the interconnect wires that connect the logic elements. As the number of logic elements and the distance between them increase, the capacitance of the interconnect wires also increases. This capacitance delays signal propagation through the wires, thereby increasing the overall design delay. Another factor that can cause delays in FPGA routing is routing congestion. The routing resources of an FPGA are limited, and if there are many logic elements to connect, routing congestion occurs. Routing congestion increases the distance between logic elements, which in turn increases the capacitance of the interconnect wires, causing delays.

A tapped delay line is a digital signal processing technique used to implement a thermometer code. In a thermometer code, each bit of a binary number is represented by a separate signal line, and the lines corresponding to "on" bits represent the value of the binary number. To implement a thermometer code using a tapped delay line, a series of delay elements representing each bit is used. The input binary number is converted into a series of pulses, with each pulse representing a 1 bit of the binary number. These pulses are fed into the tapped delay line after being delayed by different amounts depending on their bit position. In the output of the tapped delay line, each output signal line represents a bit of the binary number, and the "on" lines represent the value of the binary number. This technique is commonly used in digital-to-analog converters (DACs) to convert digital signals into analog signals.

In an FPGA, a carry chain block is a hardware block used to perform fast arithmetic operations, especially addition and subtraction. In digital circuits, the addition and subtraction of multi-bit numbers require the calculation of carry bits, which can become a bottleneck in high-speed operations. Carry chain blocks handle the calculation of these carry bits efficiently, enabling faster and more efficient arithmetic operations. A carry chain block is typically composed of a series of full adder circuits connected in a specific way to form a carry chain. Each full adder circuit calculates one bit of the output and the carry bit that is passed to the next stage in the chain. By connecting these full adder circuits in a chain, the carry bit can propagate through the chain during one clock cycle, allowing for fast addition and subtraction of multi-bit numbers. In addition to providing fast arithmetic operations, carry chain blocks can also be used to implement counters and other sequential circuits that require carry bit calculations.

A timing report tool is a software tool used to analyze the timing performance of a design implemented in an FPGA. This tool generates a report that provides information about the timing characteristics of the design. This report includes information on timing characteristics such as data path delay, critical path, setup and hold times, clock skew, and maximum operating frequency. The data path delay is the time it takes for a data signal to propagate through the logic elements of the FPGA.

A multiplexer, abbreviated as "MUX," is an electronic circuit that selects one of several input signals and forwards the selected input to an output line. The input-output structure of a multiplexer generally consists of multiple input lines, select lines, and one or more output lines. The number of input lines corresponds to the number of input signals that the multiplexer can select from, and the select lines determine the selected input signal. For example, a 4-to-1 multiplexer has four input lines, one output line, and select lines that determine which of the four input signals is transmitted to the output. The select lines can be controlled by a binary code that represents the selected input line. Multiplexers are frequently used in digital systems to reduce the number of wires needed to transmit data and control signals. They can be used to implement functions such as data selectors, memory address decoders, and bus arbitration circuits.

The present invention provides an FPGA configuration that allows a plurality of TDCs to be combined and used for various purposes.

According to one aspect of the present invention, an FPGA may be programmed to include: a plurality of TDCs (Time to Digital Converters), each said TDC configured to determine a time difference between the occurrence of two signals and having an input node pair for receiving said two signals; and a multiplexer configured to selectively connect a plurality of input signals to the input node pair of each of said TDCs.

In this case, said plurality of input signals may include a first start signal and a first stop signal, and said multiplexer may be configured to supply said first start signal and said first stop signal in common to said plurality of TDCs, and the FPGA may be further programmed to include a calibration unit for determining a corrected time difference between said first start signal and said first stop signal from the average value of a plurality of time differences output by said plurality of TDCs with respect to said first start signal and said first stop signal.

In this case, said plurality of input signals may include a first start signal and a first stop signal, and each of said TDCs may include: a first delay line part to which an input pulse having a width equal to the time difference between the occurrences of said first start signal and said first stop signal is input; a code conversion part for converting the order of elements of a thermometer code output by said first delay line part and outputting the result; and a calculation part for determining said time difference determined by each of said TDCs using the converted code output by said code conversion part, wherein said converted code is one in which the order of the elements of said thermometer code has been sorted according to a predetermined criterion, and said predetermined criterion may be the data path delay from the output node of said first input pulse to the respective output nodes of a plurality of flip-flops included in said first delay line part.

Alternatively, said plurality of input signals may include a first start signal and a first stop signal, and each of said TDCs may include: a plurality of delay line parts to which an input pulse having a width equal to the time difference between the occurrences of said first start signal and said first stop signal is input; a code conversion part for merging a plurality of thermometer codes output by said plurality of delay line parts and outputting a single converted code; and a calculation part for determining said time difference determined by each of said TDCs using said converted code, wherein said converted code is one in which the order of the elements of said plurality of thermometer codes has been sorted according to a predetermined criterion, and said predetermined criterion may be the data path delay from the output node of said first input pulse to the respective output nodes of a plurality of flip-flops in said plurality of delay line parts.

Alternatively, said plurality of input signals may include a first start signal, a first stop signal, and a second stop signal, and said multiplexer may be configured to supply said first start signal and said first stop signal to a first TDC among said plurality of TDCs, and to supply said first start signal and said second stop signal to a second TDC among said plurality of TDCs, and a first time difference, which is the time difference between the occurrences of said first start signal and said first stop signal determined by said first TDC, may be provided to a circuit connected to said first TDC, and a second time difference, which is the time difference between the occurrences of said first start signal and said second stop signal determined by said second TDC, may be provided to a circuit connected to said second TDC.

Alternatively, said plurality of input signals may include a first start signal, a second start signal, and a first stop signal, and said multiplexer may be configured to supply said first start signal and said first stop signal to a first TDC among said plurality of TDCs, and to supply said second start signal and said first stop signal to a second TDC among said plurality of TDCs, and a first time difference, which is the time difference between the occurrences of said first start signal and said first stop signal determined by said first TDC, may be provided to a circuit connected to said first TDC, and a second time difference, which is the time difference between the occurrences of said second start signal and said first stop signal determined by said second TDC, may be provided to a circuit connected to said second TDC.

According to one aspect of the present invention, there is provided a non-transitory computer-readable recording medium on which a binary file including configuration data is recorded, said configuration data being for programming an FPGA to implement a digital circuit comprising: a plurality of TDCs (Time to Digital Converters), each said TDC configured to determine a time difference between the occurrences of two signals and having an input node pair for receiving said two signals; and a multiplexer configured to selectively connect a plurality of input signals to the input node pair of each of said TDCs.

In this case, said plurality of input signals may include a first start signal and a first stop signal, and said multiplexer may be configured to supply said first start signal and said first stop signal in common to said plurality of TDCs, and said digital circuit may be characterized by further comprising a calibration unit for determining a corrected time difference between said first start signal and said first stop signal from the average value of a plurality of time differences output by said plurality of TDCs with respect to said first start signal and said first stop signal.

In this case, said plurality of input signals may include a first start signal and a first stop signal, and each of said TDCs may include: a first delay line part to which an input pulse having a width equal to the time difference between the occurrences of said first start signal and said first stop signal is input; a code conversion part for converting the order of elements of a thermometer code output by said first delay line part and outputting the result; and a calculation part for determining said time difference determined by each of said TDCs using the converted code output by said code conversion part, wherein said converted code is one in which the order of the elements of said thermometer code has been sorted according to a predetermined criterion, and said predetermined criterion may be characterized by being the data path delay from the output node of said first input pulse to the respective output nodes of a plurality of flip-flops included in said first delay line part.

Alternatively, said plurality of input signals may include a first start signal and a first stop signal, and each of said TDCs may include: a plurality of delay line parts to which an input pulse having a width equal to the time difference between the occurrences of said first start signal and said first stop signal is input; a code conversion part for merging a plurality of thermometer codes output by said plurality of delay line parts and outputting a single converted code; and a calculation part for determining said time difference determined by each of said TDCs using said converted code, wherein said converted code is one in which the order of the elements of said plurality of thermometer codes has been sorted according to a predetermined criterion, and said predetermined criterion may be characterized by being the data path delay from the output node of said first input pulse to the respective output nodes of a plurality of flip-flops in said plurality of delay line parts.

Alternatively, said plurality of input signals may include a first start signal, a first stop signal, and a second stop signal, and said multiplexer may be configured to supply said first start signal and said first stop signal to a first TDC among said plurality of TDCs, and to supply said first start signal and said second stop signal to a second TDC among said plurality of TDCs, and it may be characterized in that a first time difference, which is the time difference between the occurrences of said first start signal and said first stop signal determined by said first TDC, is provided to a circuit connected to said first TDC, and a second time difference, which is the time difference between the occurrences of said first start signal and said second stop signal determined by said second TDC, is provided to a circuit connected to said second TDC.

Alternatively, said plurality of input signals may include a first start signal, a second start signal, and a first stop signal, and said multiplexer may be configured to supply said first start signal and said first stop signal to a first TDC among said plurality of TDCs, and to supply said second start signal and said first stop signal to a second TDC among said plurality of TDCs, and it may be characterized in that a first time difference, which is the time difference between the occurrences of said first start signal and said first stop signal determined by said first TDC, is provided to a circuit connected to said first TDC, and a second time difference, which is the time difference between the occurrences of said second start signal and said first stop signal determined by said second TDC, is provided to a circuit connected to said second TDC.

According to one aspect of the present invention, a TDC system may be provided, which includes a PCB board (600) including the aforementioned FPGA (1); and a computing device (700) for acquiring said time difference from said PCB board.

According to the present invention, an FPGA configuration can be provided that allows a plurality of TDCs to be combined and used for various purposes.
FIG. 1 is a block diagram illustrating the configuration of an FPGA according to an embodiment of the present invention.
FIG. 2 is a diagram for explaining an input pulse input to a first delay line part according to an embodiment of the present invention.
FIG. 3 shows the configuration of the first delay line part according to an embodiment of the present invention.
FIG. 4 is a diagram for explaining the indices of the buffers in FIG. 3.
FIG. 5 is a table for explaining the data path delay according to an embodiment of the present invention.
FIGS. 6a and 6b show a parallel configuration of a plurality of delay line parts according to an embodiment of the present invention.
FIG. 7a shows the configuration of the first delay line part and the second delay line part of FIG. 6b, and FIG. 7b is a diagram for explaining the operation of the code conversion part when two delay line parts are used according to an embodiment of the present invention.
FIG. 8 is a graph showing the delay depending on whether the code conversion part is applied, according to an embodiment of the present invention.
FIG. 9 is a diagram for explaining the arrangement criteria for flip-flop output values and the increase in the number of taps in FIG. 8, depending on whether the code conversion part is applied, according to an embodiment of the present invention.
FIG. 10 is a diagram for explaining a method of providing input pulses for a plurality of TDCs using a plurality of input signals, according to an embodiment of the present invention.
FIG. 11 shows the input signals and the TDC input pulse from FIG. 10.
FIG. 12 is a graph for confirming jitter using a TDC according to an embodiment of the present invention.
FIG. 13 is a diagram for explaining the operation of a multiplexer in another embodiment of the present invention.
FIG. 14 shows the input pulse of the TDC according to the signals input to each TDC in FIG. 13.
FIG. 15 is a diagram for explaining the operation of a multiplexer in another embodiment of the present invention.
FIG. 16 shows the input pulse of the TDC according to the signals input to each TDC in FIG. 15.
FIG. 17 is a block diagram of a TDC system provided according to an embodiment of the present invention.

Hereinafter, embodiments of the present invention will be described with reference to the accompanying drawings. However, the present invention is not limited to the embodiments described herein and may be implemented in various other forms. The terminology used in this specification is for the purpose of helping to understand the embodiments and is not intended to limit the scope of the present invention. In addition, singular forms used herein include plural forms as well, unless the context clearly indicates otherwise.

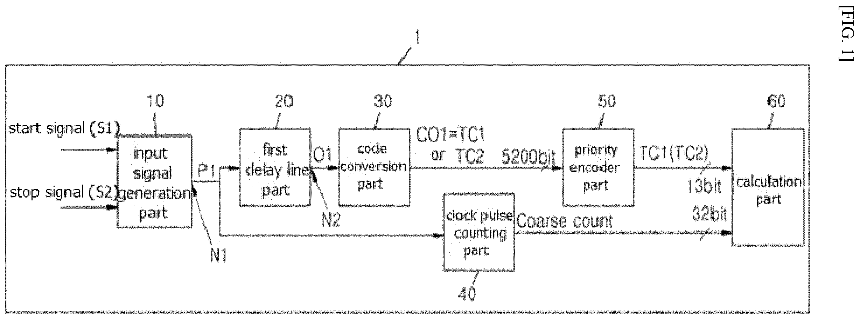

FIG. 1 is a block diagram illustrating the configuration of an FPGA according to an embodiment of the present invention.

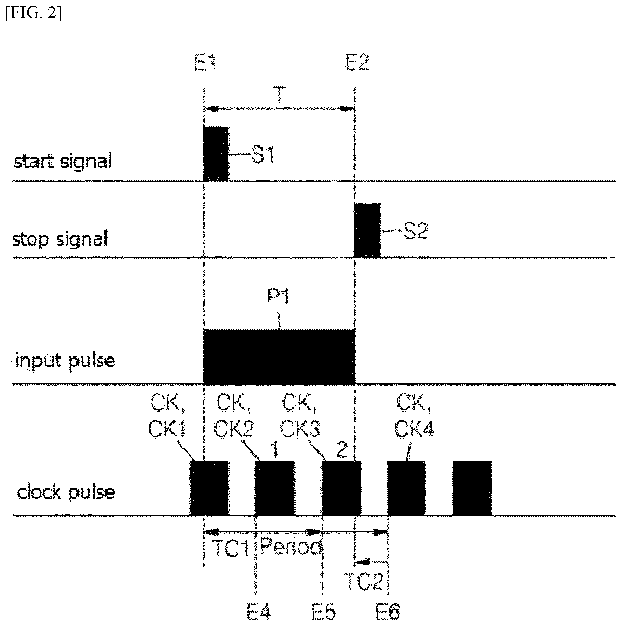

FIG. 2 is a diagram for explaining an input pulse input to a first delay line part according to an embodiment of the present invention.

Hereinafter, description will be made with reference to both FIGS. 1 and 2.

The FPGA (1) may include an input signal generation part (10), a first delay line part (20), a code conversion part (30), a clock pulse count part (40), a priority encoder part (50), and a calculation part (60).

Specifically, the components of the aforementioned FPGA (1) may be the components of a TDC (Time to Digital Converter).

As shown in FIG. 2, the input signal generation part (10) can generate an input pulse (P1) having a width equal to the time difference (T) between the rising edge (E1) of a given start signal (S1) and the rising edge (E2) of a given stop signal (S2). The input signal generation part (10) may be composed of the logic gates necessary for said generation.

The first delay line part (20) may receive the input pulse (P1) having a width equal to the time difference (T) between the occurrences of the start signal (S1) and the stop signal (S2). And the first delay line part (20) can output a thermometer code (O1). At this time, the thermometer code is, for example, an 8-bit value composed of the output values of the flip-flops included in the first delay line part (20), and the output value of each flip-flop can be referred to as an element of the thermometer code.

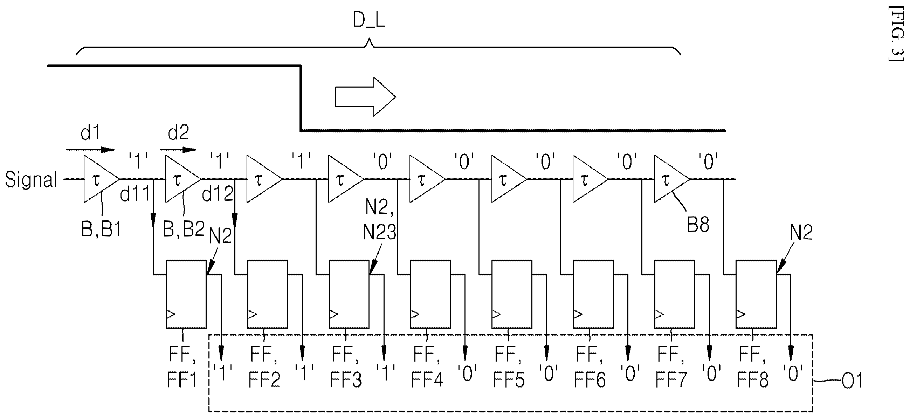

FIG. 3 shows the configuration of the first delay line part according to an embodiment of the present invention.

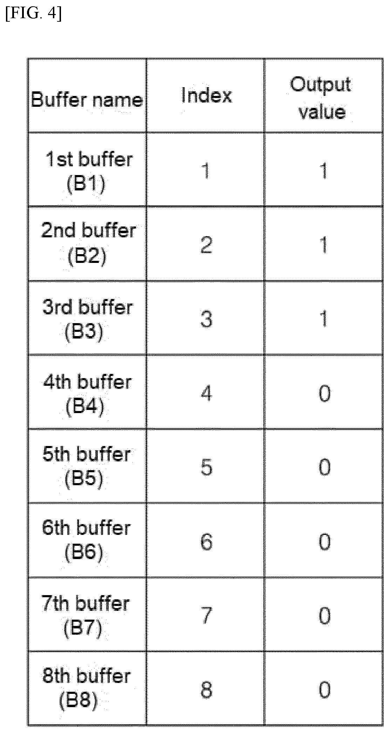

FIG. 4 is a diagram for explaining the indices of the buffers in FIG. 3.

The first delay line part (20) may include a delay line (D_L) comprising a plurality of buffers (delay elements) (B) and D-flip-flops (FF) tapped at the output terminal of each buffer (B) of said delay line.

The plurality of buffers can be connected in a cascade delay method. That is, the plurality of buffers can be arranged in the order in which the input pulse (P1) flows.

The waveform (Signal) of the input pulse (P1) in FIG. 3 can be output with a certain delay at the output terminal of each buffer (B). That is, the output value of the first buffer (B1) is output with a certain delay at the output terminal of the first buffer (B1), and the output terminal of the first buffer (B1) is connected to the input terminal of the second buffer (B2). The output value (e.g., '1') of the first buffer (B1) can also be input to the first flip-flop (FF1).

At this time, a data path delay can occur between each buffer (B) and through the flip-flops (FF). For example, a delay of d1 may occur until the input value ('1') of the first buffer (B1) is delivered to the second buffer (B2), and a delay of d11 may occur until the output value ('1') of the first buffer (B1) is delivered to the first flip-flop (FF1). Likewise, a delay occurs each time data is delivered from a previous buffer to a next buffer, and a delay occurs each time data is delivered from an arbitrary buffer to a flip-flop connected to said arbitrary buffer.

FIG. 4 is a diagram for explaining the index of a buffer according to an embodiment of the present invention.

Each field in the table of FIG. 4 indicates the buffer name, index, and the buffer's output value.

Each buffer can be assigned an index that defines the order of the buffers. For example, the first buffer (B1) is assigned index '1', the second buffer (B2) is assigned index '2', and likewise, the eighth buffer (B8) is assigned index '8'. In this way, when the buffers (B) are arranged according to the order in which the input pulse (P1) flows and indices are assigned according to that order, for example, 1000 buffers can each be assigned an index from 1 to 1000.

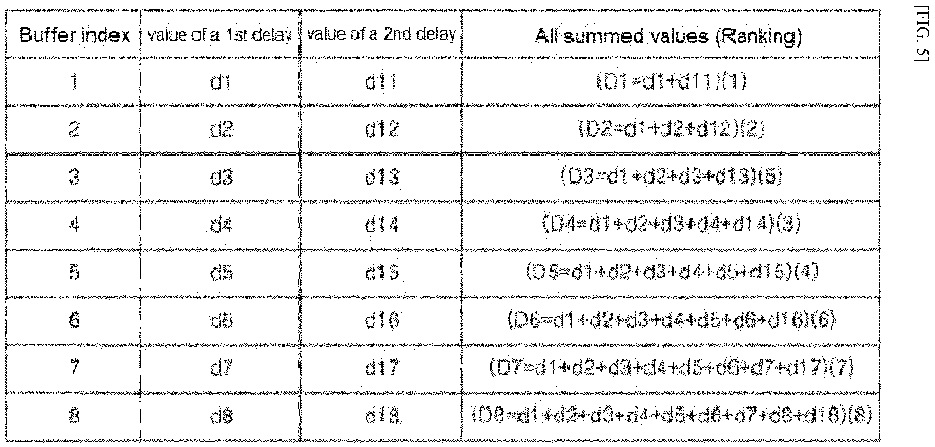

FIG. 5 is a table for explaining the data path delay according to an embodiment of the present invention.

Referring to FIGS. 1 and 5, the code conversion part (30) can convert the order of the elements (e.g., 1, 2, 3, 4, 5, 6, 7, 8) of the thermometer code (O1) (e.g., 11100000) output from the first delay line part (20) and output the result. At this time, the code output by the code conversion part (30) (e.g., 11010000) (the order of the corresponding buffer indices is 1, 2, 4, 5, 3, 6, 7, 8) can be referred to as a 'converted code (CO1)'.

The converted code (CO1) output by the code conversion part (30) may be one in which the order of the elements of the thermometer code (O1) is sorted based on a predetermined criterion. At this time, said predetermined criterion may be the data path delay from the output node (N1) of the input pulse (P1) to the respective output nodes (N2) of the plurality of flip-flops (FF) included in the first delay line part (20). This will be explained in detail with reference to FIG. 5.

Each field in the table shown in FIG. 5 can indicate the buffer index number, the value of the first delay, the value of the second delay, and the sum value (rank). At this time, said rank can indicate the rank with respect to all the sum values. At this time, the buffer with the smallest sum value has the 1st rank, and the buffer with the largest sum value can have the last rank. Or, the reverse is also possible in other embodiments.

As described above in FIG. 3, said sum value can mean the time it takes for data to be delivered from the node (N1) where the input pulse (P1) is output to an arbitrary flip-flop (e.g., FF4).

The first delay, which is the time it takes for the input value of an arbitrary buffer to be delivered to the next consecutive buffer, and the second delay, which is the time it takes for the output value of the arbitrary buffer to be delivered to the input of the flip-flop connected to said arbitrary buffer, can occur.

At this time, for each buffer, the value obtained by adding the value of the first delay and the value of the second delay can be referred to as the data path delay.

Referring to FIGS. 3 and 5 together, when the indices of the buffers are listed in order, the rank of the sum of the first delay value and the second delay value may be different from the rank of the buffer index number. For example, in the case of the third buffer, the buffer arrangement rank is 3rd, so the index number is '3', but the rank of the sum value can be '5'. To look at this in detail, for data to be delivered to the third flip-flop (FF3), it must pass through the first buffer (B1), the second buffer, and the third buffer. At this time, a certain delay (d1, d2, d3) occurs each time it passes through the first buffer (B1), the second buffer (B2), and the third buffer (B3), and a delay (d13) can also occur until the data output from the third buffer (B3) is output as the output value of the third flip-flop (FF3). That is, the delay until the data is delivered from the output node (N1) of the input pulse (P1) to the output node (N2, N23) of the third flip-flop (FF3) can be the sum of d1, d2, d3, and d13.

In this way, the delay (i.e., the sum value) until the data is delivered to the output node of each flip-flop (FF3) can be calculated.

For example, in this embodiment, the buffer index for the third flip-flop (FF3) is 3, and the buffer index for the fourth flip-flop (FF4) is 4. That is, the fourth flip-flop (FF4) has to pass through one more buffer than the third flip-flop (FF3), but nevertheless, the sum of the delays to the output node of the third flip-flop with buffer index 3 could be larger.

The code conversion part (30) can convert the order of the elements of said thermometer code (O1) based on the calculated delay (sum value) (e.g., from the smallest sum value).

The converted code (CO1) output by the code conversion part (30) can be provided to the priority encoder part (50).

The priority encoder part (50) can digitalize a long thermometer code. For example, the priority encoder part (50) can convert a 5200-bit thermometer code into a 13-bit binary code. For example, if there are 5200 of the buffers (delay elements) (B) and the flip-flops (FF) connected to said buffers as described in FIG. 3, a continuous binary number sequence of 5200 is output, which can be represented by a 13-bit binary number.

That is, the priority encoder part (50) can represent the first thermometer code (TC1) and the second thermometer code (TC2) of 5200 bits as a 13-bit binary number, as the time-dependent output value (CO1) of the code conversion part (30).

Referring to FIG. 2, the first thermometer code (TC1) may be the code output by the code conversion part (30) in relation to the rising edge of the input pulse (P1) at the time point (E4) of the rising edge of the first clock pulse (CK2) that occurs after the occurrence of the rising edge (E1) of the input pulse (P1). The first thermometer code (TC1) represented by 13 bits can be provided as input to the calculation part (60).

And the second thermometer code (TC2) may be the code output by the code conversion part (30) in relation to the falling edge (E2) of the input pulse (P1) at the time point (E6) of the rising edge of the first clock pulse (CK4) that occurs after the occurrence of the falling edge (E2) of the input pulse (P1). The second thermometer code (TC2) represented by 13 bits can be provided as input to the calculation part (60).

At this time, the time interval of the first thermometer code (TC1) and the time interval of the second thermometer code (TC2) can be smaller than the period of the clock pulse (CK).

Referring again to FIGS. 1 and 2, the clock pulse count part (40) can receive the input pulse (P1) from the input signal generation part (10).

The clock pulse count part (40) can count the number of clock pulses (CK) that occur during the duration (T) of the input pulse (P1). For example, in FIG. 2, since there are two rising edges of the clock pulses, edges (E4, E5), that occur during the period when the input pulse (P1) is in the on state, the counted value can be 2.

The output value (Coarse count) of the clock pulse count part (40), i.e., said counted value, is provided to the calculation part (60).

Referring to FIGS. 1 and 2, the calculation part (60) can determine the value of said time difference using said first thermometer code (TC1), said second thermometer code (TC2), and the number of said counted clock pulses. For example, said time difference can be 2*Period + TC1 - TC2.

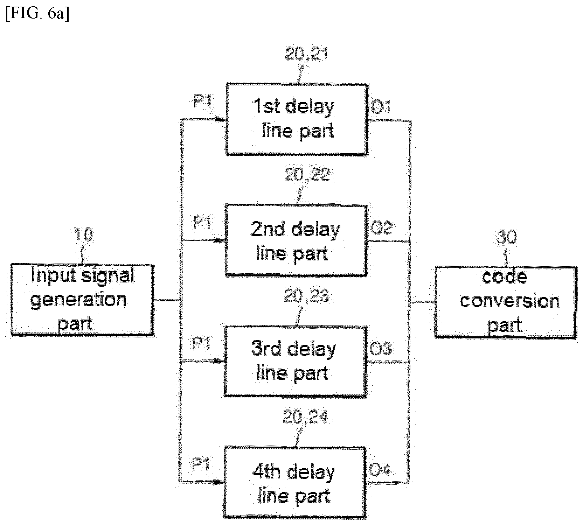

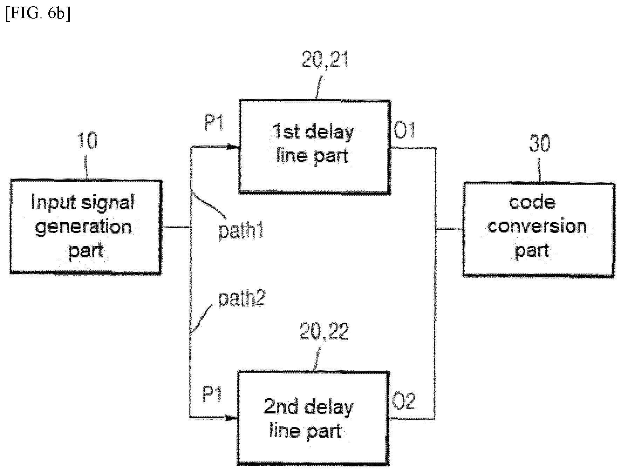

FIGS. 6a and 6b show a parallel configuration of a plurality of delay line parts according to an embodiment of the present invention.

As shown in FIG. 6a, the delay line part (20) may be connected in parallel with two or more. At this time, the input pulse (P1) output from the input signal generation part (10) can be input to the first delay line part (21), the second delay line part (22), the third delay line part (23), and the fourth delay line part (24), respectively. And the first thermometer code (O1), the second thermometer code (O2), the third thermometer code (O3), and the fourth thermometer code (O4) output from the first delay line part (21), the second delay line part (22), the third delay line part (23), and the fourth delay line part (24) can be input to the code conversion part (30).

As in another embodiment shown in FIG. 6b, it can be assumed that two delay line parts (20) are connected in parallel.

For example, the input pulse (P1) output from the input signal generation part (10) can be provided along a first path (path1) where the output terminal of the input signal generation part (10) and the input terminal of the first delay line part (21) are connected, and along a second path (path2) where the output terminal of the input signal generation part (10) and the input terminal of the second delay line part (22) are connected.

At this time, the time it takes for the input pulse (P1) output from the input signal generation part (10) to reach the input terminal of the first delay line part (21) and the input terminal of the second delay line part (22) can be different. This is because an input delay exists due to the difference in length between said first path (path1) and said second path (path2). In the embodiment of FIG. 6b, because the length of the first path (path1) is shorter than the length of the second path (path2), it can be seen that the input time interval of the input pulse (path1) through the first path (path1) is shorter than the input time interval of the input pulse (path2) through the second path (path2).

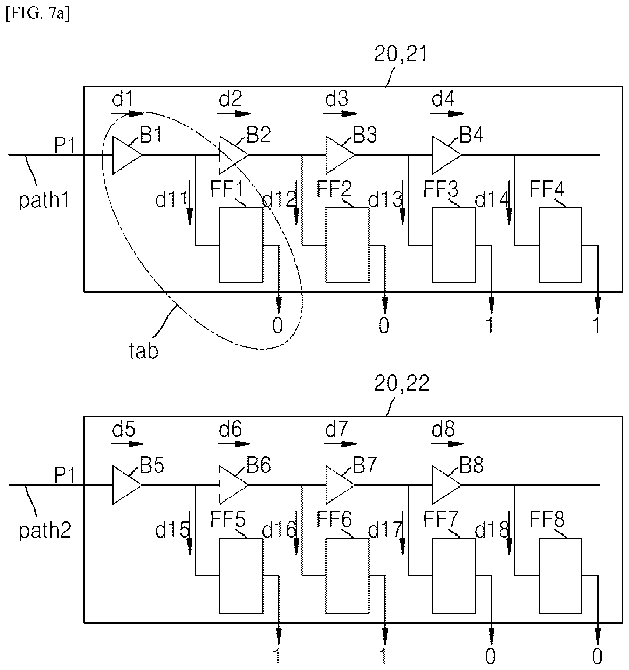

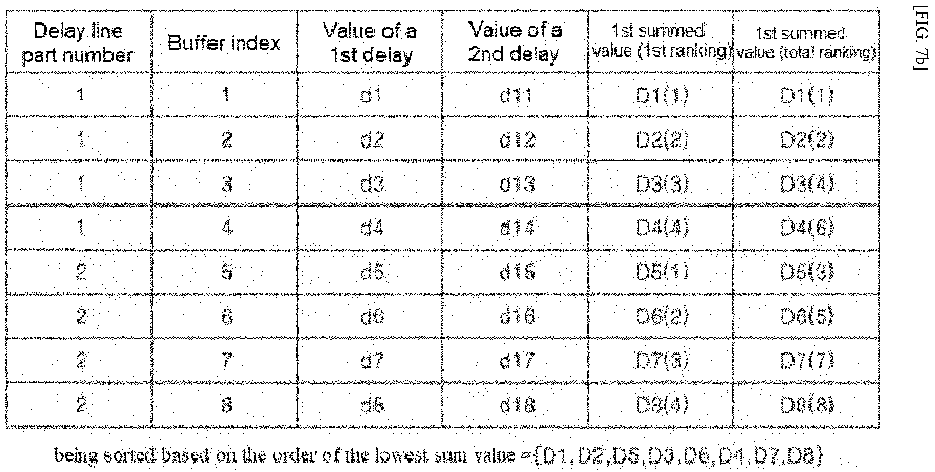

FIG. 7a shows the configuration of the first delay line part and the second delay line part of FIG. 6b, and FIG. 7b is a diagram for explaining the operation of the code conversion part when two delay line parts are used according to an embodiment of the present invention.

For convenience of explanation in FIG. 7a, it is shown that the buffers and flip-flops within each delay line part each include 4.

In the table of FIG. 7b, each field can indicate the delay line part number, the buffer index number, the value of the first delay, the value of the second delay, the first sum value (first rank), and the first sum value (overall rank). At this time, said first rank can indicate the rank for each sum value with respect to the buffer indices of the buffers within each delay line part. And said overall rank can indicate the rank for each sum value with respect to the buffer indices of all buffers in the first delay line part and the second delay line part.

The code conversion part (30) is configured to sort and merge the elements of the first set (e.g., {(D1, 1), (D2, 2), (D3, 3), (D4, 4)}), which lists the sum values of the elements of the thermometer code output by the first delay line part (21) and the buffer index pairs in ascending order of the sum value, and the elements of the second set (e.g., {(D5, 5), (D6, 6), (D7, 7), (D8, 8)}), which lists the sum values of the elements of the thermometer code output by the second delay line part (22) and the index pairs in ascending order of the sum value, to generate a single converted code.

That is, each element of said first set and each element of said second set can be sorted based on the ascending order of the sum values.

For example, the output values based on the buffer index in the first delay line part (21) are {1, 2, 3, 4}, and the output values based on the buffer index in the second delay line part (22) are {5, 6, 7, 8}. And in the embodiment of FIGS. 6b and 7a, the delay (d1) can be smaller than the delay (d5). Therefore, the sorted order can be (D1, 1), (D2, 2), (D5, 5), (D3, 3), (D6, 6), (D4, 4), (D7, 7), (D8, 8). The output values of the flip-flops for each buffer index can be sorted in the said sorted order. For example, the sorted values (buffer index) can be 0(1), 0(2), 1(4), 1(6), 1(3), 1(5), 0(7), 0(8).

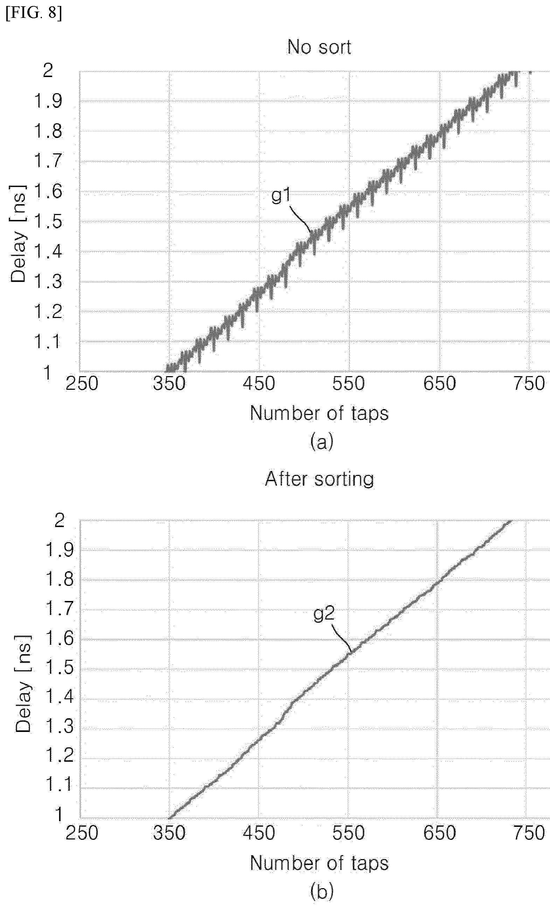

As described above, when a plurality of delay line parts (20) are used, slightly different input delays may occur depending on the placement. Hereinafter, FIG. 8 shows the delay according to the placement when a plurality of delay line parts are used.

FIG. 8 is a graph showing the delay depending on whether the code conversion part is applied, according to an embodiment of the present invention.

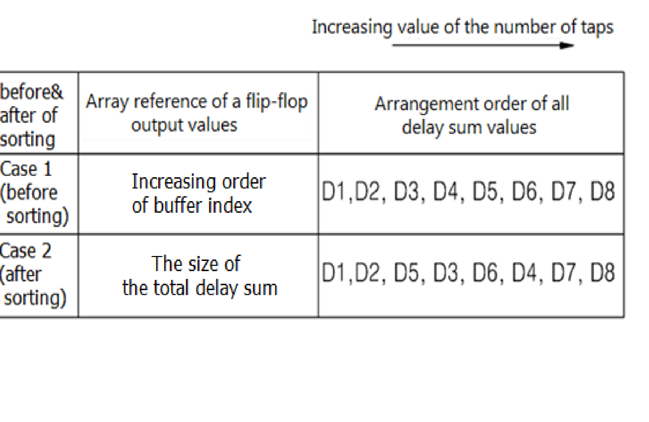

FIG. 9 is a diagram for explaining the arrangement criteria for flip-flop output values and the increase in the number of taps in FIG. 8, depending on whether the code conversion part is applied, according to an embodiment of the present invention.

(a) of FIG. 8 shows a delay graph according to the number of taps in a state where the code conversion part (30) is not applied, and (b) of FIG. 8 shows a delay graph according to the number of taps in a state where the code conversion part (30) is applied.

The fields in the table of FIG. 9 include before and after sorting, the arrangement criteria for flip-flop output values, and the arrangement order of the total delay sum values.

Hereinafter, description will be made with reference to both FIGS. 8 and 9.

The horizontal axis of the graphs (g1, g2) indicates the number of taps. Referring to FIG. 7b, one tap can mean a pair of one buffer (delay element) (e.g., B1) and the flip-flop (FF1) connected to it. For example, if the total number of pairs of buffers and their connected flip-flops is 1000, the total number of taps would be 1000.

The vertical axis of the graphs (g1, g2) indicates the delay time (ns). Said delay time can mean the sum of the delays it takes for data to be delivered to the output node of the flip-flop tapped at each buffer, as described in FIG. 5.

Referring to FIGS. 7a to 9 together, an increase in the number of taps in the graph (g1) can mean an increase in the buffer index. For example, when the number of taps on the horizontal axis of the graph (g1) is 4, it can mean buffer index 4. At this time, the delay value on the vertical axis of the graph (g1) is D4 (=d1+d2+d3+d4+d14), as in FIG. 7b. For example, when the number of taps is 5, it can mean buffer index 5. At this time, the delay value on the vertical axis of the graph (g1) is D5 (=d5+d15), as in FIG. 7b. At this time, referring to FIG. 9, D4 > D5. Here, it can be seen that the delay observed at each flip-flop of the tap does not increase as the tap index (e.g., index 4 -> index 5) increases, but cases where it locally decreases also occur.

On the other hand, an increase in the number of taps in the graph (g2) does not mean an increase in the buffer index, but an increase in the position according to the sorted order in a state where the output values of each flip-flop are sorted by the code conversion part (30). For example, when the number of taps on the horizontal axis of the graph (g2) is 4, the order of the positions of the sorted buffer indices is 1, 2, 5, 3, which can mean buffer index 3. And the delay value on the vertical axis of the graph (g2) in this case can be D3 (=d1+d2+d3+d13). For example, when the number of taps is 5, the order of the positions of the sorted buffer indices is 1, 2, 5, 3, 6, which can mean buffer index 6. And the delay value in this case can be D6 (=d5+d6+d16). At this time, referring to FIG. 9, D3 < D6.

That is, as in (a) of FIG. 8, when the code conversion part (30) of the present invention is not applied, it can be seen that the graph (g1) for the delay with respect to the increase in the number of taps does not exhibit a monotonically increasing property. On the other hand, as in (b) of FIG. 8, when the code conversion part (30) of the present invention is applied, it can be seen that the graph (g2) for the delay with respect to the increase in the number of taps exhibits a non-decreasing, increasing phenomenon.

For example, unlike custom semiconductors like ASICs, FPGAs, which can be designed directly through programming, can have their chip functions changed by programming. Therefore, unlike ASICs, the function of each component included in an FPGA can differ (or depending on the placement of the components), so that when the number of taps increases, the delay does not always increase but may also decrease, thus not achieving a non-decreasing, increasing phenomenon.

However, as explained, through the graph (g2), it can be confirmed that the code conversion part (30) can correct the output of the first delay line part (20).

As described above, when a plurality of delay line parts (20) are used, the code conversion part can provide sorting of the delays. As a result, it is possible to provide a TDC with high time resolution by correcting for errors due to jitter. For example, when four delay line parts are configured in parallel to have a total of 9600 taps, it is possible to provide a TDC with a resolution of 0.8 ps per tap.

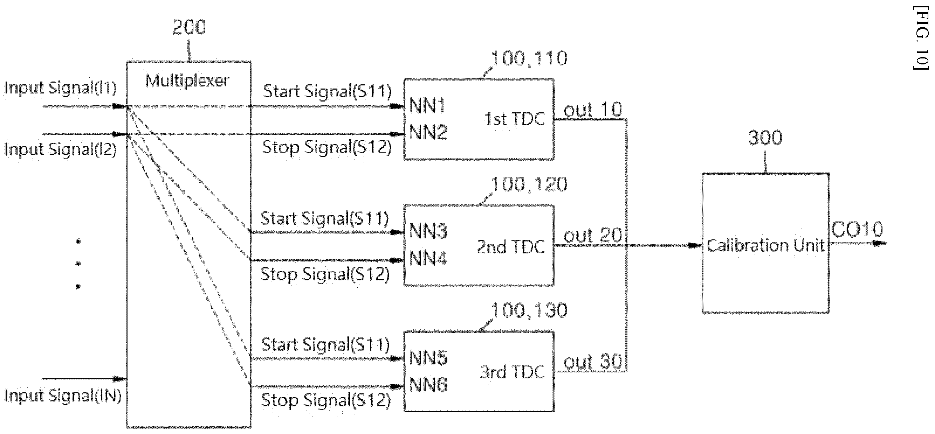

FIG. 10 is a diagram for explaining a method of providing input pulses for a plurality of TDCs using a plurality of input signals, according to an embodiment of the present invention.

To provide respective input pulses to a plurality of TDCs using a plurality of input signals, the FPGA (2) may include a plurality of TDCs (100), a multiplexer (200), and a calibration unit (300).

At this time, the plurality of TDCs (100) may each be configured to determine the time difference between the occurrences of two signals. For example, said two signals can be the same as the start signal (S1) and the stop signal (S2) of FIG. 2, and said time difference can mean T of FIG. 2.

At this time, the plurality of TDCs (100) may each include the configurations described above in FIGS. 1 to 9.

At this time, the plurality of TDCs (100) may each have an input node pair for receiving said two signals.

For example, the plurality of TDCs (100) may include a first TDC (110), a second TDC (120), and a third TDC (130). The first TDC (110) may include an input node pair, node (NN1) and node (NN2). The second TDC (120) may include an input node pair, node (NN3) and node (NN4). And the third TDC (130) may include an input node pair, node (NN5) and node (NN6).

The multiplexer (200) can selectively connect a plurality of input signals (I1, I2, ..., IN) to the input node pair of each TDC (100).

For example, as in FIG. 10, the input signals of the multiplexer (200) may include a first input signal (I1), a second input signal (I2), ..., and an Nth input signal (IN).

In one embodiment, the multiplexer (200) may supply the first input signal (I1) among said input signals in common as the start signal (S11) to the first TDC (110), the second TDC (120), and the third TDC (130), and supply the second input signal (I2) among said input signals in common as the stop signal (S12) to the first TDC (110), the second TDC (120), and the third TDC (130).

The calibration unit (300) can determine the average value of the plurality of time differences output by the plurality of TDCs (100) as the 'corrected time difference' (CO10) between the start signal (S11) and the stop signal (S12).

For example, the calibration unit (300) can calculate the average value of the output value (out10) (time difference) of the first TDC (110), the output value (out20) of the second TDC (120), and the output value (out30) of the third TDC (130). The calibration unit (300) can determine the calculated average value as the corrected time difference (CO10) between the start signal (S11) and the stop signal (S12) and output it.

Said corrected time difference (CO10) has a higher probability of being more accurate compared to each of said output values (out10, out20, out30).

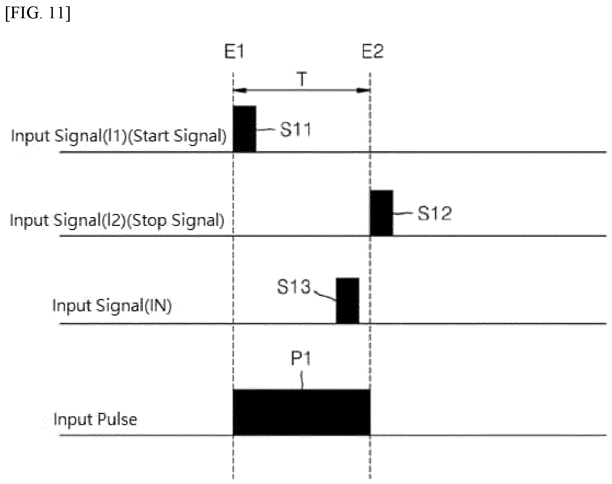

FIG. 11 shows the input signals and the TDC input pulse from FIG. 10.

The horizontal axis of each input signal and input pulse represents the flow of time.

Explaining with reference to FIGS. 10 and 11 together, the multiplexer (200) can receive the input signal (I1), the input signal (I2), and the input signal (IN), but since only the input signal (I1) and the input signal (I2) are provided in common as the start signal and stop signal to the TDCs (100), the input pulses (P1) generated within the TDCs (100) can all be the same.

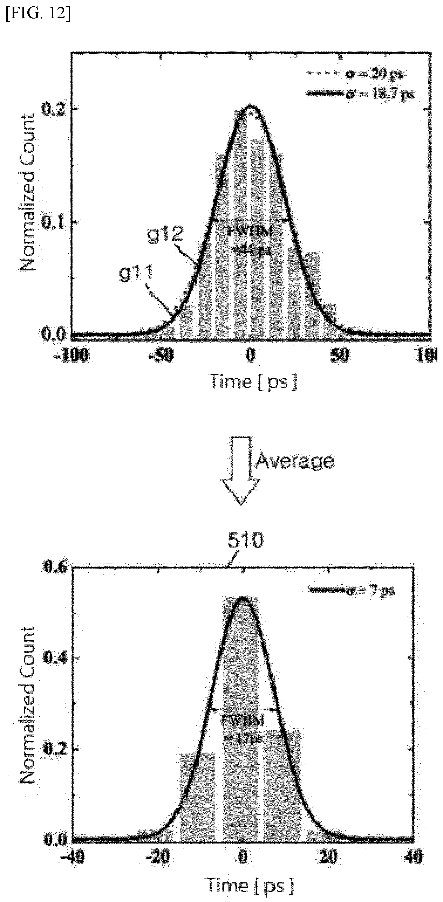

FIG. 12 is a graph for confirming jitter using a TDC according to an embodiment of the present invention.

The left chart (500) is the case where the calibration unit (300) of FIG. 10 is not applied, and the right chart (510) is the case where the calibration unit (300) of FIG. 10 is applied.

That is, said left chart (500) is a histogram showing the distribution when measuring the final result value repeatedly, in the case where one of said output values (out10, out20, out30) is selected as the final result value without using the calibration unit (300) of FIG. 10. And said right chart (510) is a histogram showing the distribution when measuring the final result value repeatedly, in the case where said corrected time difference (CO10) is selected as the final result value using the calibration unit (300) of FIG. 10.

The horizontal axis of each graph (g1, g2, g3) of the charts (500, 510) represents time (unit ps), and the vertical axis represents the normalized count value.

In the left chart (500), the standard deviation of the first graph (g11) (dotted line) is 20 ps, and the standard deviation of the second graph (g12) (solid line) is 18.7 ps. At this time, the full width at half maximum (FWHM) in the first graph (g11) and the second graph (g12) is 44 ps.

In the right chart (510), the standard deviation of the third graph (g13) is 7 ps. At this time, the FWHM in the third graph (g13) is 17 ps.

Comparing the FWHM of the left chart (500) and the right chart, it can be seen that the FWHM of the right chart is less than half the FWHM of the left chart (510). That is, thanks to the application of the calibration unit (300), it can be confirmed that the error in delay due to jitter, etc., within the FPGA is reduced.

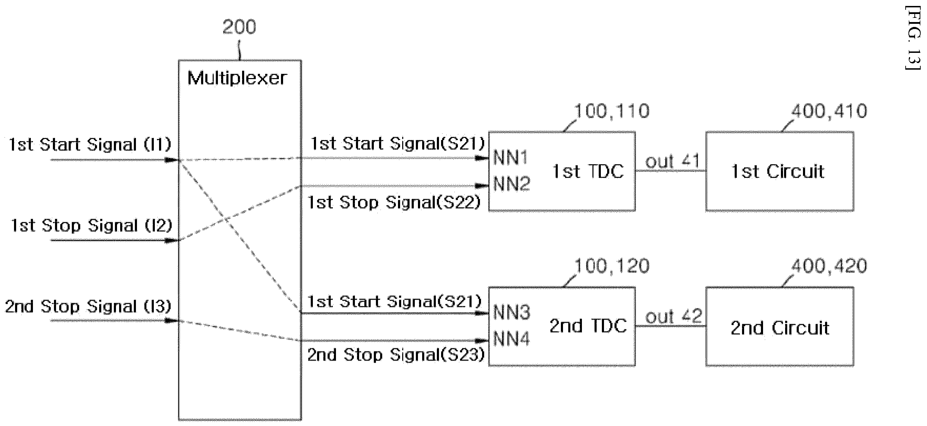

FIG. 13 is a diagram for explaining the operation of a multiplexer in another embodiment of the present invention.

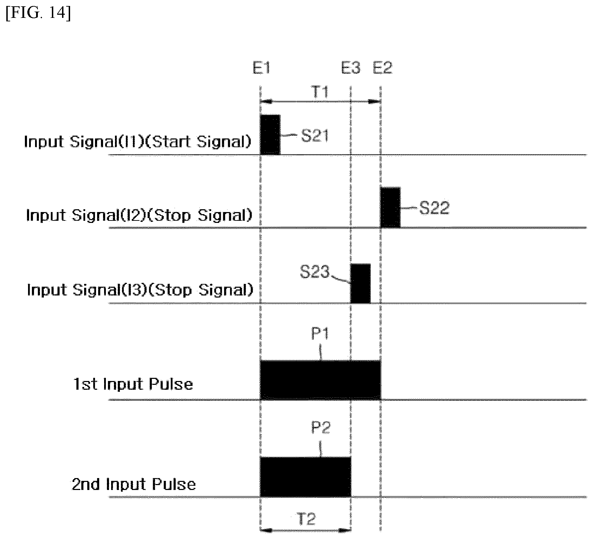

FIG. 14 shows the input pulse of the TDC according to the signals input to each TDC in FIG. 13.

Hereinafter, description will be made with reference to both FIGS. 13 and 14.

The plurality of input signals (I1, I2, I3) input to the multiplexer (200) may include a first start signal (S21), a first stop signal (S22), and a second stop signal (S23).

The multiplexer (200) may supply the first start signal (S21) and the first stop signal (S22) to the first TDC (110) among the plurality of TDCs (100), and supply the first start signal (S21) and the second stop signal (S23) to the second TDC (120) among the plurality of TDCs (100).

A first input pulse (P1) can be generated within the first TDC (110) through the first start signal (S21) and the first stop signal (S22). The first time difference (out41, T1), which is the time difference between the occurrences of the first start signal (S21) and the first stop signal (S22) determined by the first TDC (110), can be provided to a circuit (e.g., a first circuit (400, 410)) connected to the first TDC (110).

A second input pulse (P2) can be generated within the second TDC (120) through the first start signal (S21) and the second stop signal (S23). The second time difference (out42, T2), which is the time difference between the occurrences of the first start signal (S21) and the second stop signal (S23) determined by the second TDC (120), can be provided to a circuit (e.g., a second circuit (400, 420)) connected to the second TDC (120).

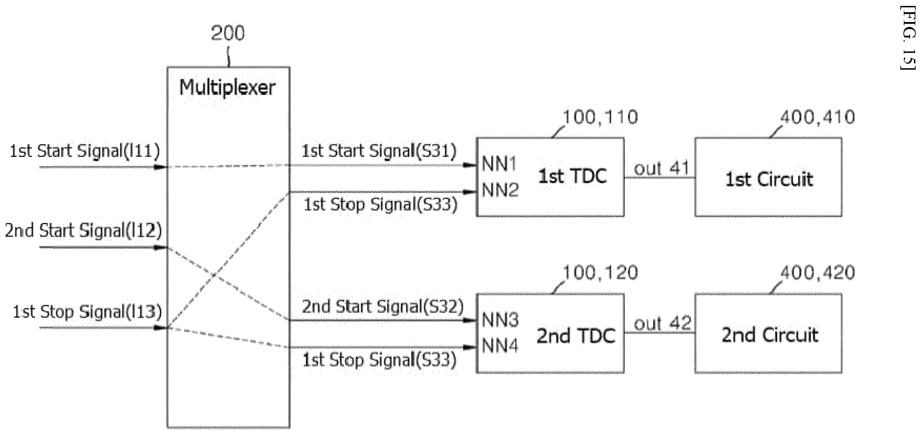

FIG. 15 is a diagram for explaining the operation of a multiplexer in another embodiment of the present invention.

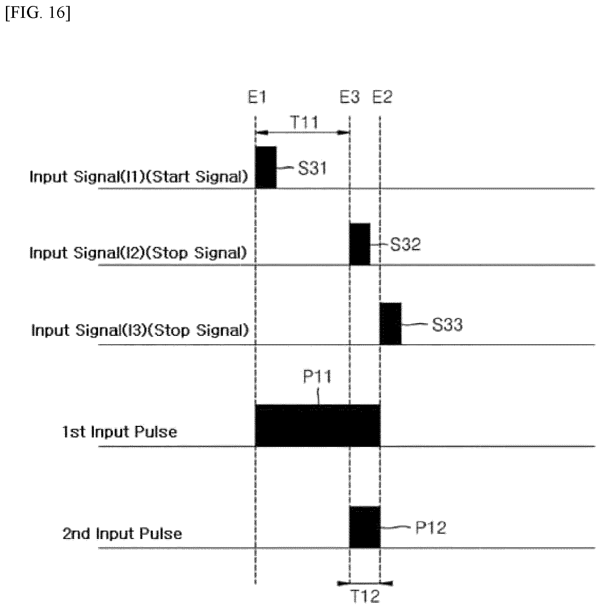

FIG. 16 shows the input pulse of the TDC according to the signals input to each TDC in FIG. 15.

Hereinafter, description will be made with reference to both FIGS. 15 and 16.

The plurality of input signals (I11, I12, I13) input to the multiplexer (200) may include a first start signal (S31), a second start signal (S32), and a first stop signal (S33).

The multiplexer (200) may supply the first start signal (S31) and the first stop signal (S33) to the first TDC (110) among the plurality of TDCs (100), and supply the second start signal (S32) and the first stop signal (S33) to the second TDC (120) among the plurality of TDCs (100).

A first input pulse (P11) can be generated within the first TDC (110) using the first start signal (S31) and the first stop signal (S33). The first time difference (out41, T11), which is the time difference between the occurrences of the first start signal (S31) and the first stop signal (S33) determined by the first TDC (110), can be provided to a circuit (e.g., a first circuit (400, 410)) connected to the first TDC (110).

A second input pulse (P12) can be generated within the second TDC (120) through the second start signal (S32) and the first stop signal (S33). The second time difference (out42, T12), which is the time difference between the occurrences of the second start signal (S32) and the first stop signal (S33) determined by the second TDC (120), can be provided to a circuit (e.g., a second circuit (400, 420)) connected to the second TDC (120).

At this time, the first circuit (410) and the second circuit (420) may be the calibration unit (300).

As described above through FIGS. 10 to 16, by averaging the operating results of a plurality of TDCs and reconfiguring the input signals of the TDCs using a multiplexer, an FPGA can be provided that enhances the accuracy and usability of the TDCs.

In one embodiment of the present invention, a binary file including configuration data for programming said FPGA to implement a digital circuit comprising the aforementioned plurality of TDCs and the aforementioned multiplexer using the aforementioned FPGA may be recorded on a non-transitory computer-readable recording medium according to the present invention.

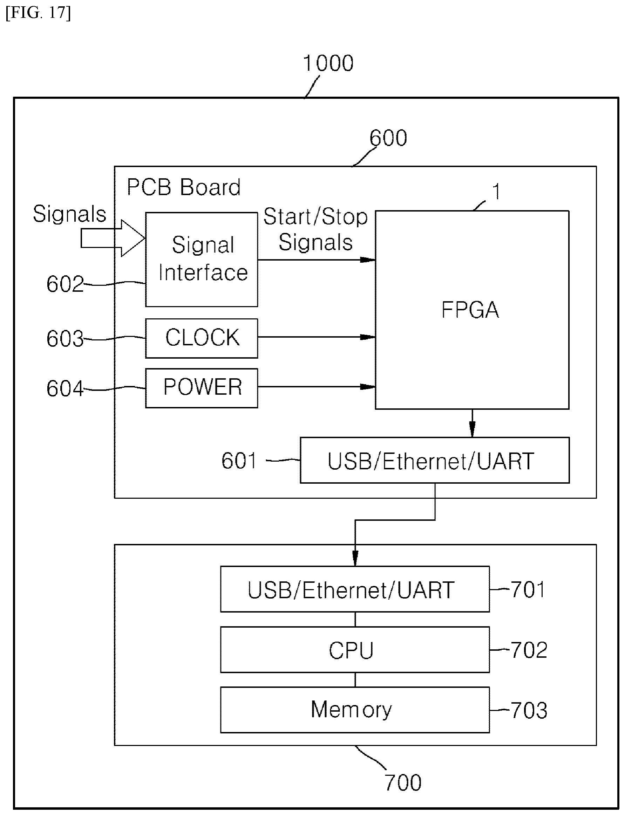

FIG. 17 is a block diagram of a TDC system provided according to an embodiment of the present invention.

The TDC system (1000) may include a PCB board (600) and a computing device (700).

The PCB board (600) is a device capable of digital signal processing and may include the aforementioned FPGA (1), a data interface (601), a signal interface (602), a clock generation unit (603), and a power supply unit (604).

The data interface (601) is a device that enables data exchange between the PCB board (600) and the computing device (700), and may be composed of USB, Ethernet, or UART, but is not limited thereto.

The signal interface (602) functions to receive signals to be measured for their time difference from the outside using said FPGA (1) and deliver them to said FPGA (1).

The clock generation unit (603) can provide the train of clock pulses that said FPGA (1) counts.

The time difference value of the two selected signals, calculated by said FPGA (1), is output from the FPGA (1) and can be provided to the data interface (601). The data interface (601) can provide said time difference value of the two signals to the computing device (700).

The power supply unit (604) supplies the power used by the PCB board (600).

The computing device (700) may include a data interface (701), a CPU (702), and memory (703).

The computing device (700) is configured to execute a predetermined algorithm using the time difference value of the two selected signals received from the PCB board (600). Said received time difference value of the two signals can be processed by a process executed in the CPU (702). A program composed of instructions for executing said process may be stored in the memory (703). Said program can be loaded from the memory (703) to the CPU (702) and executed. Said memory (703) may be non-volatile memory.

Using the embodiments of the present invention described above, those skilled in the art to which the present invention pertains will be able to easily make various changes and modifications within a scope that does not depart from the essential characteristics of the present invention. The content of each claim in the scope of claims can be combined with other claims that are not cited within a scope understandable through this specification.

### [Description of Reference Numerals]

1: FPGA
10: Input signal generation part
20: First delay line part
30: Code conversion part
40: Clock pulse count part
50: Priority encoder part
60: Calculation part
100: TDC
200: Multiplexer
300: Calibration unit
400: Circuit
500: Chart
510: Chart
600: PCB board
700: Computing device
1000: TDC system

## Claims

1. An FPGA programmed to comprise: a plurality of TDCs (Time to Digital Converters), each said TDC being configured to determine a time difference between the occurrences of two signals and having an input node pair for receiving said two signals; and a multiplexer configured to selectively connect a plurality of input signals to the input node pair of each of said TDCs.

2. The FPGA of claim 1, wherein said plurality of input signals includes a first start signal and a first stop signal, said multiplexer is configured to supply said first start signal and said first stop signal in common to said plurality of TDCs, and the FPGA is further programmed to include a calibration unit for determining a corrected time difference between said first start signal and said first stop signal from an average value of a plurality of time differences output by said plurality of TDCs with respect to said first start signal and said first stop signal.

3. The FPGA of claim 1, wherein said plurality of input signals includes a first start signal and a first stop signal, each of said TDCs comprises: a first delay line part to which an input pulse having a width corresponding to the time difference between the occurrences of said first start signal and said first stop signal is input; a code conversion part for converting an order of elements of a thermometer code output by said first delay line part and outputting the result; and a calculation part for determining said time difference determined by each of said TDCs using the converted code output by said code conversion part; wherein the converted code is a code in which the order of the elements of said thermometer code is sorted based on a predetermined criterion, and said predetermined criterion is a data path delay from an output node of said first input pulse to respective output nodes of a plurality of flip-flops included in said first delay line part.

4. The FPGA of claim 1, wherein said plurality of input signals includes a first start signal and a first stop signal, each of said TDCs comprises: a plurality of delay line parts to which an input pulse having a width corresponding to the time difference between the occurrences of said first start signal and said first stop signal is input; a code conversion part for merging a plurality of thermometer codes output by said plurality of delay line parts and outputting a single converted code; and a calculation part for determining said time difference determined by each of said TDCs using said converted code; wherein the converted code is a code in which the order of the elements of said plurality of thermometer codes is sorted based on a predetermined criterion, and said predetermined criterion is a data path delay from an output node of said first input pulse to respective output nodes of a plurality of flip-flops in said plurality of delay line parts.

5. The FPGA of claim 1, wherein said plurality of input signals includes a first start signal, a first stop signal, and a second stop signal, said multiplexer is configured to supply said first start signal and said first stop signal to a first TDC among said plurality of TDCs, and to supply said first start signal and said second stop signal to a second TDC among said plurality of TDCs, and a first time difference, which is the time difference between the occurrences of said first start signal and said first stop signal determined by said first TDC, is provided to a circuit connected to said first TDC, and a second time difference, which is the time difference between the occurrences of said first start signal and said second stop signal determined by said second TDC, is provided to a circuit connected to said second TDC.

6. The FPGA of claim 1, wherein said plurality of input signals includes a first start signal, a second start signal, and a first stop signal, said multiplexer is configured to supply said first start signal and said first stop signal to a first TDC among said plurality of TDCs, and to supply said second start signal and said first stop signal to a second TDC among said plurality of TDCs, and a first time difference, which is the time difference between the occurrences of said first start signal and said first stop signal determined by said first TDC, is provided to a circuit connected to said first TDC, and a second time difference, which is the time difference between the occurrences of said second start signal and said first stop signal determined by said second TDC, is provided to a circuit connected to said second TDC.

7. A non-transitory computer-readable recording medium on which a binary file including configuration data is recorded, said configuration data for programming an FPGA to implement a digital circuit comprising: a plurality of TDCs (Time to Digital Converters), each said TDC being configured to determine a time difference between the occurrences of two signals and having an input node pair for receiving said two signals; and a multiplexer configured to selectively connect a plurality of input signals to the input node pair of each of said TDCs.

8. The non-transitory computer-readable recording medium of claim 7, wherein said plurality of input signals includes a first start signal and a first stop signal, said multiplexer is configured to supply said first start signal and said first stop signal in common to said plurality of TDCs, and said digital circuit is further **characterized by** comprising a calibration unit for determining a corrected time difference between said first start signal and said first stop signal from an average value of a plurality of time differences output by said plurality of TDCs with respect to said first start signal and said first stop signal.

9. The non-transitory computer-readable recording medium of claim 7, wherein said plurality of input signals includes a first start signal and a first stop signal, each of said TDCs comprises: a first delay line part to which an input pulse having a width corresponding to the time difference between the occurrences of said first start signal and said first stop signal is input; a code conversion part for converting an order of elements of a thermometer code output by said first delay line part and outputting the result; and a calculation part for determining said time difference determined by each of said TDCs using the converted code output by said code conversion part; wherein the converted code is a code in which the order of the elements of said thermometer code is sorted based on a predetermined criterion, and said predetermined criterion is **characterized by** being a data path delay from an output node of said first input pulse to respective output nodes of a plurality of flip-flops included in said first delay line part.

10. The non-transitory computer-readable recording medium of claim 7, wherein said plurality of input signals includes a first start signal and a first stop signal, each of said TDCs comprises: a plurality of delay line parts to which an input pulse having a width corresponding to the time difference between the occurrences of said first start signal and said first stop signal is input; a code conversion part for merging a plurality of thermometer codes output by said plurality of delay line parts and outputting a single converted code; and a calculation part for determining said time difference determined by each of said TDCs using said converted code; wherein the converted code is a code in which the order of the elements of said plurality of thermometer codes is sorted based on a predetermined criterion, and said predetermined criterion is **characterized by** being a data path delay from an output node of said first input pulse to respective output nodes of a plurality of flip-flops in said plurality of delay line parts.

11. The non-transitory computer-readable recording medium of claim 7, wherein said plurality of input signals includes a first start signal, a first stop signal, and a second stop signal, said multiplexer is configured to supply said first start signal and said first stop signal to a first TDC among said plurality of TDCs, and to supply said first start signal and said second stop signal to a second TDC among said plurality of TDCs, and is **characterized in that** a first time difference, which is the time difference between the occurrences of said first start signal and said first stop signal determined by said first TDC, is provided to a circuit connected to said first TDC, and a second time difference, which is the time difference between the occurrences of said first start signal and said second stop signal determined by said second TDC, is provided to a circuit connected to said second TDC.

12. The non-transitory computer-readable recording medium of claim 7, wherein said plurality of input signals includes a first start signal, a second start signal, and a first stop signal, said multiplexer is configured to supply said first start signal and said first stop signal to a first TDC among said plurality of TDCs, and to supply said second start signal and said first stop signal to a second TDC among said plurality of TDCs, and is **characterized in that** a first time difference, which is the time difference between the occurrences of said first start signal and said first stop signal determined by said first TDC, is provided to a circuit connected to said first TDC, and a second time difference, which is the time difference between the occurrences of said second start signal and said first stop signal determined by said second TDC, is provided to a circuit connected to said second TDC.

13. A TDC system, comprising: a PCB board (600) including the FPGA (1) of any one of claims 1 to 6; and a computing device (700) for acquiring said time difference from said PCB board.
